# EUROPÄISCHE PATENTSCHRIFT

(11) **EP 2 684 635 B1**
(45) Veröffentlichungstag und Bekanntmachung des Hinweises auf die Patenterteilung: **08.06.2016**
(21) Anmeldenummer: 13152444.9
(22) Anmeldetag: 24.01.2013
(51) Int. Cl.: B23K 26/00, B23K 26/36, B23K 26/38, B23K 26/40, H01L 21/78, B28D 5/00

(54) **Substrat und Verfahren zur Bruchvorbereitung eines Substrats für mindestens ein Leistungshalbleiterbauelement**
Substrate and method for preparing the fracture of a substrate for at least a power semiconductor device
Substrat et procédé destiné à préparer la rupture d'un substrat pour au moins un composant semi-conducteur de puissance

(30) Priorität: 11.07.2012 DE 102012212131
(43) Veröffentlichungstag der Anmeldung: 15.01.2014
(73) Patentinhaber: SEMIKRON Elektronik GmbH & Co. KG, 90431 Nürnberg (DE)
(72) Erfinder: Krauss, Norbert, 90453 Nürnberg (DE); Theis, Georg, 91161 Hilpoltstein (DE)

(56) Entgegenhaltungen:
- WO-A1-2013/094025
- DE-A1-102008 043 539
- JP-A- H07 273 069
- US-A1- 2010 261 301

## Beschreibung

Die Erfindung betrifft ein Verfahren zur Bruchvorbereitung eines Substrats für mindestens ein Leistungshalbeiterbauelement gemäß dem Oberbegriff vom Anspruch 1. Weiterhin betrifft die Erfindung ein diesbezügliches Substrat gemäß dem Oberbegriff vom Anspruch 10.

Bei aus dem Stand der Technik bekannten Leistungshalbleitermodulen sind im Allgemeinen auf einem Substrat Leistungshalbleiterbauelemente, wie z.B. Leistungshalbleiterschalter und Dioden angeordnet und mittels einer Leiterschicht des Substrats, Bonddrähten und/oder einem Folienverbund miteinander elektrisch leitend verbunden. Die Leistungshalbleiterschalter liegen dabei im Allgemeinen in Form von Transistoren, wie z.B. IGBTs (Insulated Gate Bipolar Transistor) oder MOSFETs (Metal Oxide Semiconductor Field Effect Transistor), oder in Form von Thyristoren vor. Die auf dem Substrat angeordneten Leistungshalbleiterbauelemente sind dabei häufig elektrisch zu einer einzelnen oder mehreren sogenannten Halbbrückenschaltungen verschalten, die üblicherweise zum Gleich- und Wechselrichten von elektrischen Spannungen und Strömen verwendet werden. Das Substrat ist in der Regel direkt oder indirekt mit einem Kühlkörper verbunden.
Zur Herstellung eines Leistungshalbleitermoduls werden Leistungshalbleiterbauelemente auf dem Substrat angeordnet und mit dem Substrat verbunden. Das Substrat kann dabei z.B. in Form eines DCB-Substrats vorliegen. Das Substrat weist eine strukturierte elektrisch leitende Metallschicht auf, die infolge ihrer Struktur Leiterbahnen ausbildet. Die Leistungshalbleiterbauelemente werden über die Leiterbahnen miteinander verbunden, so dass durch die Leistungshalbleiterbauelemente fließende Lastströme, welche eine hohe Stromstärke aufweisen können, auch durch die Leiterbahnen der elektrisch leitenden Metallschicht fließen. Zur Herstellung eines DCB-Substrats werden techniküblich z.B. ein Metallblech einheitlicher Dicke auf einen elektrisch nicht leitenden Isolierstoffkörper, der üblicherweise aus einer Keramik besteht, gebondet und anschließend die Leiterbahnenstruktur aus dem Metallblech geätzt.
Das Substrat wird üblicherweise in Form einer größeren Einheit hergestellt, die anschließend durch Brechen zu Substrateinzeleinheiten vereinzelt wird. Die Substrateinzeleinheiten bilden jeweilig z.B. das Substrat für ein Leistungshalbleitermodul. Das Brechen des Substrats kann dabei sowohl vor als auch nach dem Verbinden der Leistungshalbleiterbauelemente mit dem Substrat erfolgen. Beim Stand der Technik wird vor dem Brechen ein konstanter Materialabtrag mittels eines Laserstrahls am Isolierstoffkörper des Substrats entlang gewünschter Bruchkanten des Substrats durchgeführt und somit das Substrat und insbesondere der Isolierstoffköper des Substrat gezielt entlang der gewünschten Bruchkanten mechanisch einheitlich geschwächt. Beim Brechen des Substrats wird das Substrat derart mechanisch belastet, dass an der gewünschten Bruchkante eine hohe mechanische Belastung des Substrats entsteht, so dass dieses entlang der gewünschten Bruchkante bricht.
Beim Brechen des Substrats tritt das Problem auf, dass am Isolierstoffkörper häufig unerwünschte Ausbrüche an der Bruchkante und insbesondere in den Ecken entstehen und das Substrat somit unbrauchbar wird, da dessen elektrische Isolationsfestigkeit nicht mehr sichergestellt ist.

Aus der DE 10 2008 043 539 A1 ist ein Verfahren gemäß dem Oberbegriff vom Anspruch 1 Laserritzen von spröden Bauteilen zur Vorbereitung für dessen spätere Vereinzelung durch Einbringen von sackartigen Einschüssen eines Laserstrahls bekannt, wobei die Einschüsse linienförmig aneinander gereiht werden und eine Laserritzlinie bilden, die als Bruchinitüerungslinie dient, wobei auf einem Bauteil zumindest zwei einander in einem Kreuzungspunkt kreuzende Laserritzlinien eingebracht werden, wobei in den Kreuzungspunkt mindestens ein gezielt gesteuerter und nicht zufällig entstehender Kreuzungspunkt-Einschuss eingebracht wird, der das Bauteil gezielt am Kreuzungspunkt schwächt. Weiter offenbart DE 10 2008 043 539 A1 ein Substrat gemäß dem Oberbegriff vom Anspruch 10.
Aus der JPH 07273069 A ist ein Wafer bekannt in den zur Vereinzelung zu Chips Linien eingeritzt werden.
Es ist Aufgabe der Erfindung, beim Brechen eines Substrats für mindestens ein Leistungshalbeiterbauelement, unerwünschte Ausbrüche am Isolierstoffkörper des Substrats zu reduzieren.

Diese Aufgabe wird gelöst durch ein Verfahren gemäß Anspruch 1 zur Bruchvorbereitung eines Substrats für mindestens ein Leistungshalbeiterbauelement mit folgenden Verfahrensschritten:
a) Bereitstellen des Substrats, wobei das Substrat einen elektrisch nicht leitenden Isolierstoffkörper aufweist,
b) Materialabtrag am Isolierstoffkörper entlang gewünschter Bruchkanten des Substrats, wobei der Materialabtrag derart durchgeführt wird, dass in Eckbereichen an denen mindestens zwei gewünschte Bruchkanten zusammentreffen, entlang der mindestens zwei gewünschten Bruchkanten ein gegenüber dem Materialabtrag, welche in den übrigen Bereichen der gewünschten Bruchkanten durchgeführt wird, höherer Materialabtrag durchgeführt wird, wobei die entlang einer gewünschten Bruchkante verlaufende Länge eines Eckbereichs 0,5% bis 30% des entlang der gewünschten Bruchkante verlaufenden Abstands zwischen zwei benachbarten Eckpunkten der gewünschten Bruchkante, an denen mindestens zwei gewünschte Bruchkanten zusammentreffen, beträgt.

Weiterhin wird diese Aufgabe gelöst durch ein Substrat gemäß Anspruch 10 für mindestens ein Leistungshalbeiterbauelement, wobei das Substrat einen elektrisch nicht leitenden Isolierstoffkörper aufweist, wobei entlang gewünschter Bruchkanten des Substrats, Material des Isolierstoffkörpers abgetragen ist, wobei in Eckbereichen an denen mindestens zwei gewünschte Bruchkanten zusammentreffen entlang der mindestens zwei gewünschten Bruchkanten mehr Material pro Längeneinheit abgetragen ist als in den übrigen Bereichen entlang der gewünschten Bruchkanten, wobei die entlang einer gewünschten Bruchkante verlaufende Länge eines Eckbereichs 0,5% bis 30% des entlang der gewünschten Bruchkante verlaufenden Abstands zwischen zwei benachbarten Eckpunkten der gewünschten Bruchkante, an denen mindestens zwei gewünschte Bruchkanten zusammentreffen, beträgt.

Vorteilhafte Ausbildungen der Erfindung ergeben sich aus den abhängigen Ansprüchen.

Vorteilhafte Ausbildungen des Verfahrens ergeben sich analog zu vorteilhaften Ausbildungen des Substrats und umgekehrt.

Es erweist sich als vorteilhaft, wenn der Materialabtrag mittels eines Laserstrahls durchgeführt wird, da ein Laserstrahl einen besonders variablen und zuverlässigen Materialabtrag am Isolierstoffkörper ermöglicht.

Ferner erweist es sich als vorteilhaft, wenn der Materialabtrag mittels eines gepulsten Laserstrahls durchgeführt wird und der gepulste Laserstrahl zur Erzielung des Materialabtrags, entlang den gewünschten Bruchkanten, Vertiefungen in den Isolierstoffkörper einbringt, da durch das Einbringen von Vertiefen auf einfache Art und Weise ein variabler und auf den Isolierstoffkörper abgestimmter Materialabtrag erzielbar ist.

Weiterhin erweist sich als vorteilhaft, wenn in Eckbereichen an denen mindestens zwei gewünschte Bruchkanten zusammentreffen, vom Laserstrahl mehr Vertiefungen pro Längeneinheit entlang der gewünschten Bruchkanten in den Isolierstoffkörper eingebracht werden als in den übrigen Bereichen der gewünschten Bruchkanten.

Durch diese Maßnahme ist auf einfache Art und Weise ein variabler und auf den Isolierstoffkörper abgestimmter Materialabtrag erzielbar.

Weiterhin erweist sich als vorteilhaft, wenn die Vertiefungen vom gepulsten Laserstrahl in den Isolierstoffkörper eingebracht werden, indem in einem ersten Teilverfahrensschritt vom Laserstrahl erste Vertiefungen entlang der gewünschten Bruchkanten des Substrats in den Isolierstoffkörper eingebracht werden und in einem zweiten Teilverfahrensschritt vom Laserstrahl in den Eckbereichen an denen mindestens zwei gewünschte Bruchkanten zusammentreffen entlang den gewünschten Bruchkanten zweite Vertiefungen in den Isolierstoffkörper eingebracht werden. Hierdurch kann auf besonderes einfache Art und Weise ein variabler Materialabtrag entlang den gewünschten Bruchkanten realisiert werden.

Ferner erweist es sich als vorteilhaft, wenn die ersten und zweiten Vertiefungen derart angeordnet sind, dass die Mitten der ersten und zweiten Vertiefungen örtlich übereinstimmen oder die Mitten der ersten und zweiten Vertiefungen zueinander versetzt angeordnet sind. Hierdurch kann auf besonders einfache Art und Weise eine genaue Steuerung der Höhe des Materialabtrags erzielt werden.

Ferner erweist es sich als vorteilhaft, wenn in den Eckbereichen an denen mindestens zwei gewünschte Bruchkanten zusammentreffen, die Leistung des Laserstrahls höher ist als die Leistung des Laserstrahls in den übrigen Bereichen der gewünschten Bruchkanten. Durch eine Erhöhung der Leistung des Laserstrahls in Eckbereichen an denen mindestens zwei gewünschte Bruchkanten zusammentreffen kann auf besonderes einfache Art und Weise ein variabler Materialabtrag, entlang den gewünschten Bruchkanten realisiert werden.

Weiterhin erweist sich als vorteilhaft, wenn beim ersten und zweiten Teilverfahrensschritt der Laserstrahl die gleiche Leistung aufweist, da dann die Laserstrahlerzeugungseinrichtung, die den Laserstrahl erzeugt, besonders einfach aufgebaut sein kann.

Weiterhin erweist sich ein Verfahren zum Brechen eines Substrats für mindestens ein Leistungshalbeiterbauelement als vorteilhaft, wobei das Verfahren ein Verfahren zur Bruchvorbereitung eines Substrats für mindestens ein Leistungshalbeiterbauelement nach einem der vorhergehenden Ansprüche beinhaltet, wobei folgender weiterer Verfahrensschritt durchgeführt wird:
c) Brechen des Substrats entlang der gewünschten Bruchkanten des Substrats.

Ausführungsbeispiele der Erfindung sind in den Figuren dargestellt und werden im Folgenden näher erläutert. Dabei zeigen:
- FIG 1: eine schematisierte Ansicht von oben auf ein erfindungsgemäßes Substrat,
- FIG 2: eine schematisierte Schnittansicht einer ersten Ausbildung eines erfindungsgemäßen Substrats,
- FIG 3: eine schematisierte Schnittansicht einer weiteren Ausbildung eines erfindungsgemäßen Substrats,
- FIG 4: eine schematisierte Schnittansicht einer weiteren Ausbildung eines erfindungsgemäßen Substrats.

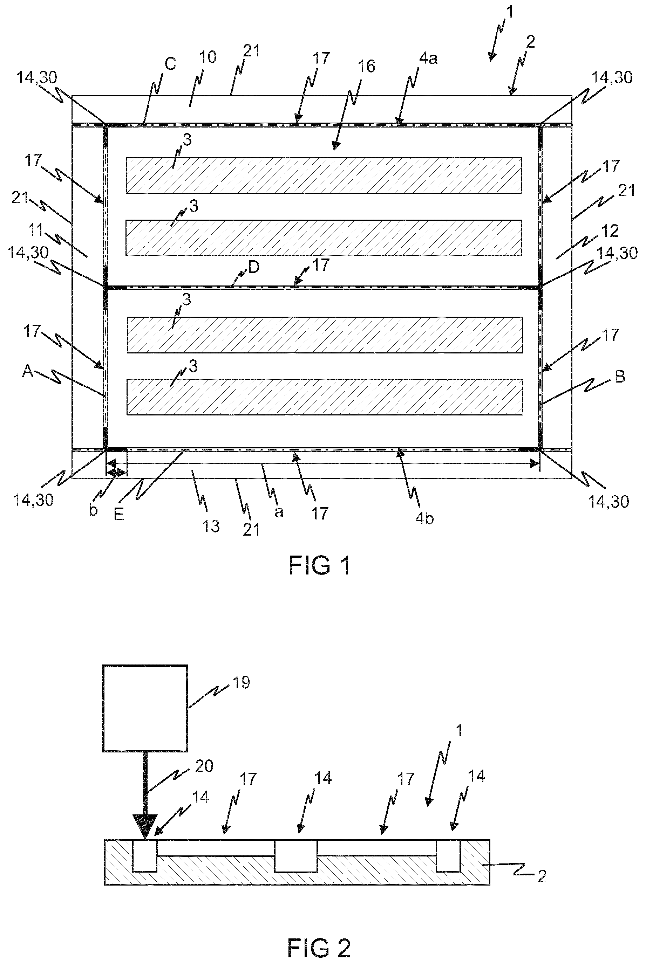

In FIG 1 ist eine schematisierte Ansicht von oben auf ein erfindungsgemäßes Substrat 1 dargestellt. In FIG 2 ist eine schematisierte Schnittansicht einer ersten Ausbildung des erfindungsgemäßen Substrats 1 entlang einer gewünschten Bruchkante A dargestellt. Das Substrat 1 ist im Rahmen des beschrieben Ausführungsbeispiel als DCB-Substrat ausgebildet, es kann jedoch auch in Form eines anderen Substrattyps ausgebildet sein.

Das Substrat 1 weist im Rahmen des Ausführungsbeispiels einen elektrisch nicht leitenden Isolierstoffkörper 2 und eine auf dem Isolierstoffkörper 2 angeordnete elektrisch leitende strukturierte Leitungsschicht 16 auf, die infolge ihrer Struktur elektrische Leiterbahnen 3 ausbildet. Vorzugsweise weist das Substrat 1 eine weitere elektrisch leitende Leitungsschicht auf, wobei der Isolierstoffkörper 2 zwischen der strukturierten Leitungsschicht 16 und der weiteren Leitungsschicht angeordnet ist. An der weiteren Leitungsschicht ist im Allgemeinen beim fertigen Leistungshalbleitermodul ein Kühlkörper, der zur Kühlung der auf dem Substrat 1 angeordneten Leistungshalbleiterbauelemente dient, angeordnet. Die strukturierte Leitungsschicht 16 und die weitere Leitungsschicht können z.B. aus Kupfer bestehen. Der elektrisch nicht leitende Isolierstoffkörper 2 besteht vorzugsweise aus einer Keramik.

Das Substrat 1 soll beim Ausführungsbeispiel durch Brechen des Substrats 1 zu Substrateinzeleinheiten 4a und 4b vereinzeln werden. Die Substrateinzeleinheiten 4a und 4b bilden jeweilig z.B. das Substrat für ein Leistungshalbleitermodul. Das Brechen des Substrats 1 kann dabei sowohl vor als auch nach dem Verbinden der Leistungshalbleiterbauelemente mit dem Substrat 1 erfolgen.

Beim Ausführungsbeispiel weist das Substrat 1 zwei Substrateinzeleinheiten 4a und 4b in einem noch nicht vereinzelten Zustand auf, wobei die Substrateinzeleinheiten 4a und 4b jeweilig zwei Leiterbahnen 3 aufweisen. Die Substrateinzeleinheiten 4a und 4b werden fachspezifisch auch als sogenannte Nutzen bezeichnet.

In einem ersten erfindungsgemäßen Verfahrensschritt erfolgt somit ein Bereitstellen des Substrats 1.

In einem weiteren erfindungsgemäßen Verfahrensschritt erfolgt ein Materialabtrag am Isolierstoffkörper 1 entlang vom Anwender gewünschter Bruchkanten A, B, C, D und E des Substrats 1, wobei der Materialabtrag derart durchgeführt wird, dass in Eckbereichen 14 an denen mindestens zwei gewünschte Bruchkanten zusammentreffen, ein gegenüber dem Materialabtrag, welche in den übrigen Bereichen 17 der gewünschten Bruchkanten A, B, C, D und E durchgeführt wird, höherer Materialabtrag durchgeführt wird. Die gewünschten Bruchkanten A, B, C, D und E verlaufen vorzugsweise um die Substrateinzeleinheiten 4a und 4b herum bzw. zwischen den Substrateinzeleinheiten 4a und 4b. Die Eckbereiche 14 sind in FIG 1 schwarz markiert dargestellt. Die übrigen Bereiche 17 der gewünschten Bruchkanten A, B, C, D und E stellen beim Ausführungsbeispiel die zwischen den Eckbereichen 14 liegenden Bereiche der gewünschten Bruchkanten A, B, C, D und E und die zwischen den Eckbereichen 14 und den Außenkanten 21 des Isolierstoffkörpers 2 liegenden Bereiche der gewünschten Bruchkanten C und E dar. Beim Materialabtrag wird Material von dem Isolierstoffkörper 1 abgetragen und dieser hierdurch entlang der gewünschten Bruchkanten mechanisch geschwächt. Die Erfindung zeichnet sich insbesondere dadurch aus, dass entlang der gewünschter Bruchkanten A, B, C, D und E nicht der technikübliche über die gesamte Länge der gewünschten Bruchkanten konstante Materialabtrag durchgeführt wird, sondern dass in den Eckbereichen 14 ein gegenüber den übrigen Bereichen 17 der gewünschten Bruchkanten A, B, C, D und E höherer Materialabtrag durchgeführt wird.

Die mechanische Schwächung des Substrats 1 und insbesondere des Isolierstoffkörpers 2 ist somit in den Eckbereichen 14 stärker als in den übrigen Bereichen 17 der gewünschten Bruchkanten A, B, C, D und E. Beim späteren Brechen des Substrats 1 wird das Substrat 1 techniküblich derart mechanisch belastet, dass an der gewünschten Bruchkante eine hohe mechanische Belastung des Substrats entsteht, so dass dieses entlang der gewünschten Bruchkante bricht und eine zu der gewünschten Bruchkante entsprechende reale Bruchkante entsteht. Dadurch, dass bei der Erfindung das Substrats 1 und insbesondere der Isolierstoffkörpers 2 in den Eckbereichen 14 stärker geschwächt ist als in den übrigen Bereichen 17 der gewünschten Bruchkanten, erfolgt beim Brechen des Substrats 1 die Bruchausbreitung im Allgemeinen von den Eckbereichen 14 ausgehend, entlang der jeweiligen Bruchkante, in Richtung zur Mitte der Bruchkante. Es entstehen dabei nur sehr selten Ausbrüche des Isolierstoffkörpers 1 an der Bruchkante, d.h. es entstehen deutlich seltener Ausbrüche als bei der techniküblichen konstanten Schwächung des Isolierstoffkörpers 1, entlang der gesamten Bruchkante.

Die Höhe des Materialabtrags entspricht der Masse des abgetragenen Materials pro Längeneinheit entlang der gewünschten Bruchkante, wobei die Längeneinheit z.B. 1 cm betragen kann.

Vorzugsweise wird der Materialabtrag mittels eines Laserstrahls 20 durchgeführt, der in FIG 2 mit einem Pfeil schematisiert dargestellt ist. Alternativ könnte der Materialabtrag aber auch z.B. mittels Fräsen, Schleifen, Sägen oder Bohren realisiert werden. Der Laserstrahl 20 wird von einer Laserstrahlungserzeugungseinrichtung 19 erzeugt.

In FIG 2 ist eine schematisierte Schnittansicht einer ersten Ausbildung des erfindungsgemäßen Substrats 1 dargestellt. Die Laserstrahlungserzeugungseinrichtung 19 erzeugt einen kontinuierlichen Laserstrahl. Der Laserstrahl 20 wird entlang der gewünschten Bruchkanten A, B, C, D und E des Substrats 1 über das Substrat 1 geführt und solchermaßen der Materialabtrag am Isolierstoffkörper 2 realisiert. In den Eckbereichen 14 der gewünschten Bruchkanten A, B, C, D und E wird dabei die Leistung des Laserstrahls 20 gegenüber der Leistung, die der Laserstrahl in den übrigen Bereichen 17 der gewünschten Bruchkanten A, B, C, D und E aufweist erhöht und somit der Materialabtrag in den Eckbereichen 14 erhöht. Alternativ ist es auch möglich die Leistung des Laserstrahls 20 entlang der gesamten Bruchkanten nicht zu verändern, sondern statt dessen, in den Eckbereichen 14 der gewünschten Bruchkanten A, B, C, D und E die Geschwindigkeit mit der der Laserstrahl 20 entlang der gewünschten Bruchkanten bewegt wird, gegenüber der Geschwindigkeit mit der der Laserstrahl 20 in den übrigen Bereichen 17 der gewünschten Bruchkanten entlang der gewünschten Bruchkanten A, B, C, D und E bewegt wird, zu verringern.

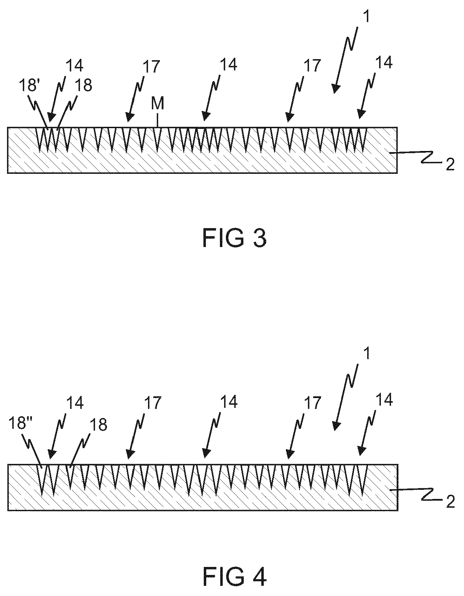

In FIG 3 ist eine schematisierte Schnittansicht einer weiteren Ausbildung des erfindungsgemäßen Substrats 1 entlang der gewünschten Bruchkante A dargestellt. Im Unterschied zu der Ausbildung der Erfindung gemäß FIG 2, wird bei der Ausbildung der Erfindung gemäß FIG 3, der Materialabtrag mittels eines gepulsten Laserstrahls durchgeführt und der gepulste Laserstrahl bringt zur Erzielung des Materialabtrags, entlang den gewünschten Bruchkanten A, B, C, D und E Vertiefungen in den Isolierstoffkörper 2 ein. In FIG 3 sind der Übersichtlichkeit nur eine erste Vertiefung 18 und eine zweite Vertiefung 18' mit einem Bezugszeichen versehen. Die Vertiefungen weisen vorzugsweise näherungsweise eine kegelförmige Form auf, die in FIG 3 als Kegelform schematisiert dargestellt ist. Die Vertiefungen weisen jeweils eine Mitte M auf. Mit jedem Laserimpuls wird beim Ausführungsbeispiel eine Vertiefung erzeugt. Vorzugsweise werden in Eckbereichen 14 an denen mindestens zwei gewünschte Bruchkanten zusammentreffen vom Laserstrahl 20 mehr Vertiefungen pro Längeneinheit entlang der gewünschten Bruchkanten in den Isolierstoffkörper eingebracht als in den übrigen Bereichen der gewünschten Bruchkanten. Die Vertiefungen werden von dem gepulsten Laserstrahl vorzugsweise in den Isolierstoffkörper eingebracht, indem in einem ersten Teilverfahrensschritt vom Laserstrahl erste Vertiefungen entlang der gewünschten Bruchkanten des Substrats in den Isolierstoffkörper eingebracht werden und in einem zweiten Teilverfahrensschritt vom Laserstrahl in Eckbereichen 14 an denen mindestens zwei gewünschte Bruchkanten zusammentreffen entlang den gewünschten Bruchkanten zweite Vertiefungen in den Isolierstoffkörper eingebracht werden. Die Mitten M der ersten und zweiten Vertiefungen sind dabei zueinander entlang der jeweiligen Bruchkante versetzt angeordnet, wobei die Mitten M von unmittelbar benachbarten ersten und zweiten Vertiefungen zueinander beliebige Abstände aufweisen können, so dass die die ersten und zweiten Vertiefungen auch ineinander greifen können oder vollkommen getrennt voneinander sein können. Durch das zusätzliche Einbringen von zweiten Vertiefungen wird der Materialabtrag in Eckbereichen 14 an denen mindestens zwei gewünschte Bruchkanten zusammentreffen, gegenüber dem Materialabtrag, welche in den übrigen Bereichen 17 der gewünschten Bruchkanten A, B, C, D und E durchgeführt wird, erhöht.

Alternativ können in Eckbereichen 14 an denen mindestens zwei gewünschte Bruchkanten zusammentreffen vom Laserstrahl 20 mehr Vertiefungen pro Längeneinheit entlang der gewünschten Bruchkanten in den Isolierstoffkörper eingebracht werden als in den übrigen Bereichen der gewünschten Bruchkanten, indem die Pulsfrequenz des Laserstrahls in den Eckbereichen gegenüber der Pulsfrequenz des Laserstrahl 20 in den übrigen Bereichen 17 der gewünschten Bruchkanten, erhöht wird, oder indem in den Eckbereichen 14 der gewünschten Bruchkanten A, B, C, D und E die Geschwindigkeit mit der der Laserstrahl 20 entlang der gewünschten Bruchkanten bewegt wird, gegenüber der Geschwindigkeit mit der der Laserstrahl 20 in den übrigen Bereichen 17 der gewünschten Bruchkanten entlang der gewünschten Bruchkanten A, B, C, D und E bewegt wird, verringert wird.

In FIG 4 ist eine schematisierte Schnittansicht einer weiteren Ausbildung des erfindungsgemäßen Substrats 1 entlang der gewünschten Bruchkante A dargestellt. Das Ausführungsbeispiel gemäß FIG 4 entspricht dem Ausführungsbeispiel gemäß FIG 3, wobei im Unterschied zum Ausführungsbeispiel gemäß FIG 3, im Ausführungsbeispiel gemäß FIG 4, die ersten und zweiten Vertiefungen derart angeordnet sind, dass die Mitten der ersten und zweiten Vertiefungen örtlich übereinstimmen, so dass die ersten und zweiten Vertiefungen zu Gesamtvertiefungen verschmelzen. In FIG 4 ist der Übersichtlichkeit nur eine Gesamtvertiefung 18" mit einem Bezugszeichen versehen.

Bei der Ausbildung der Erfindung gemäß FIG 3 oder FIG 4 weist beim ersten und zweiten Teilverfahrensschritt der Laserstrahl die gleiche Leistung auf. Selbstverständlich ist es aber auch bei den Ausbildungen der Erfindung gemäß FIG 3 und FIG 4 möglich, dass in den Eckbereichen 14 an denen mindestens zwei gewünschte Bruchkanten zusammentreffen, die Leistung des Laserstrahls höher ist als die Leistung des Laserstrahls in den übrigen Bereichen 17 der gewünschten Bruchkanten. Durch diese Maßnahme kann z.B. die Größe der zweiten Vertiefungen gegenüber der Größe der ersten Vertiefungen vergrößert werden.

Alternativ kann das Einbringen der Vertiefungen um die in FIG 4 dargestellten Vertiefungen zu erzeugen erfindungsgemäß auch derart erfolgen, dass der Materialabtrag mittels eines gepulsten Laserstrahls durchgeführt wird und der gepulste Laserstrahl zur Erzielung des Materialabtrags, entlang der gewünschten Bruchkanten, Vertiefungen in den Isolierstoffkörper 2 einbringt, wobei in den Eckbereichen an denen mindestens zwei gewünschte Bruchkanten zusammentreffen, die Leistung des Laserstrahls höher ist als die Leistung des Laserstrahls in den übrigen Bereichen der gewünschten Bruchkanten, so dass die in den Eckbereichen 14 angeordnete Vertiefungen größer sind als in den übrigen Bereichen angeordnete Vertiefungen.

In Rahmen des Ausführungsbeispiels erfolgt nachfolgend ein Brechen des Substrats 1 entlang der gewünschten Bruchkanten A, B, C, D und E des Substrats 1. Beim Brechen des Substrats wird das Substrat derart mechanisch belastet, dass an der gewünschten Bruchkante eine hohe mechanische Belastung des Substrats entsteht, so dass dieses entlang der gewünschten Bruchkante bricht. Das Brechen des Substrats 1 kann dabei sowohl vor als auch nach dem Verbinden der Leistungshalbleiterbauelemente mit dem Substrat 1 erfolgen. Beim Brechen werden beim Ausführungsbeispiel zuerst die Seitenteile 10 und 13, und dann die Seitenteile 11 und 12 weggebrochen, und anschießend das Substrat an der gewünschten Bruchkante D gebrochen und solchermaßen in die erste und zweite Substrateinzeleinheit 4a und 4b vereinzelt.

Es sei an dieser Stelle angemerkt, dass in den Figuren gleiche Elemente mit gleichen Bezugszeichen versehen sind.

Weiterhin sei an dieser Stelle angemerkt, dass bei der vorliegenden Erfindung die entlang einer gewünschten Bruchkante verlaufende Länge b eines Eckbereichs 0,5% bis 30% des entlang der gewünschten Bruchkante verlaufenden Abstands a zwischen zwei benachbarten Eckpunkten 30 der gewünschten Bruchkante, an denen mindestens zwei gewünschte Bruchkanten zusammentreffen, beträgt (siehe FIG 1).

## Patentansprüche

1. Verfahren zur Bruchvorbereitung eines Substrats (1) für mindestens ein Leistungshalbeiterbauelement mit folgenden Verfahrensschritten:
a) Bereitstellen des Substrats (1), wobei das Substrat (1) einen elektrisch nicht leitenden Isolierstoffkörper (2) aufweist,
b) Materialabtrag am Isolierstoffkörper (2) entlang gewünschter Bruchkanten (A,B,C,D,E) des Substrats (1), wobei der Materialabtrag derart durchgeführt wird, dass in Eckbereichen (14) an denen mindestens zwei gewünschte Bruchkanten (A,B,C,D,E) zusammentreffen, entlang der mindestens zwei gewünschten Bruchkanten ein gegenüber dem Materialabtrag, welche in den übrigen Bereichen (17) der gewünschten Bruchkanten (A,B,C,D,E) durchgeführt wird, höherer Materialabtrag durchgeführt wird, **dadurch gekennzeichnet daß** die entlang einer gewünschten Bruchkante (A,B,C,D,E) verlaufende Länge (b) eines Eckbereichs (14) 0,5% bis 30% des entlang der gewünschten Bruchkante (A,B,C,D,E) verlaufenden Abstands (a) zwischen zwei benachbarten Eckpunkten (30) der gewünschten Bruchkante (A,B,C,D,E), an denen mindestens zwei gewünschte Bruchkanten (A,B,C,D,E) zusammentreffen, beträgt.

2. Verfahren nach einem der vorhergehenden Ansprüche, **dadurch gekennzeichnet, dass** der Materialabtrag mittels eines Laserstrahls (20) durchgeführt wird.

3. Verfahren nach Anspruch 2, **dadurch gekennzeichnet, dass** der Materialabtrag mittels eines gepulsten Laserstrahls (20) durchgeführt wird und der gepulste Laserstrahl (20) zur Erzielung des Materialabtrags, entlang der gewünschten Bruchkanten (A,B,C,D,E), Vertiefungen (18,18',18") in den Isolierstoffkörper (2) einbringt.

4. Verfahren nach Anspruch 3, **dadurch gekennzeichnet, dass** in Eckbereichen (14) an denen mindestens zwei gewünschte Bruchkanten zusammentreffen, vom Laserstrahl (20) mehr Vertiefungen (18,18') pro Längeneinheit entlang der gewünschten Bruchkanten (A,B,C,D,E) in den Isolierstoffkörper (2) eingebracht werden als in den übrigen Bereichen (17) der gewünschten Bruchkanten (A,B,C,D,E).

5. Verfahren nach Anspruch 4, **dadurch gekennzeichnet, dass** die Vertiefungen 18,18',18") vom gepulsten Laserstrahl (20) in den Isolierstoffkörper (2) eingebracht werden, indem in einem ersten Teilverfahrensschritt vom Laserstrahl (20) erste Vertiefungen (18') entlang der gewünschten Bruchkanten (A,B,C,D,E) des Substrats (1) in den Isolierstoffkörper (2) eingebracht werden und in einem zweiten Teilverfahrensschritt vom Laserstrahl (20) in den Eckbereichen (14) an denen mindestens zwei gewünschte Bruchkanten (A,B,C,D,E) zusammentreffen entlang den gewünschten Bruchkanten (A,B,C,D,E) zweite Vertiefungen (18') in den Isolierstoffkörper (2) eingebracht werden.

6. Verfahren nach Anspruch 5, **dadurch gekennzeichnet, dass** die ersten und zweiten Vertiefungen (18,18') derart angeordnet sind, dass die Mitten (M) der ersten und zweiten Vertiefungen (18,18') örtlich übereinstimmen oder die Mitten (M) der ersten und zweiten Vertiefungen (18,18') zueinander versetzt angeordnet sind.

7. Verfahren nach einem der Ansprüche 2 bis 6, **dadurch gekennzeichnet, dass** in den Eckbereichen (14) an denen mindestens zwei gewünschte Bruchkanten (A,B,C,D,E) zusammentreffen, die Leistung des Laserstrahls (20) höher ist als die Leistung des Laserstrahls (20) in den übrigen Bereichen (17) der gewünschten Bruchkanten (A,B,C,D,E).

8. Verfahren nach Anspruch 5 oder 6, **dadurch gekennzeichnet, dass** beim ersten und zweiten Teilverfahrensschritt der Laserstrahl (20) die gleiche Leistung aufweist.

9. Verfahren zum Brechen eines Substrats für mindestens ein Leistungshalbeiterbauelement , wobei das Verfahren ein Verfahren zur Bruchvorbereitung eines Substrats für mindestens ein Leistungshalbeiterbauelement nach einem der vorhergehenden Ansprüche beinhaltet, mit folgendem weiteren Verfahrensschritt:
c) Brechen des Substrats (1) entlang der gewünschten Bruchkanten (A,B,C,D,E) des Substrats (1).

10. Substrat für mindestens ein Leistungshalbeiterbauelement, wobei das Substrat (1) einen elektrisch nicht leitenden Isolierstoffkörper (2) aufweist, wobei entlang gewünschter Bruchkanten (A,B,C,D,E) des Substrats (1), Material des Isolierstoffkörpers (2) abgetragen ist, wobei in Eckbereichen (14) an denen mindestens zwei gewünschte Bruchkanten (A,B,C,D,E) zusammentreffen entlang der mindestens zwei gewünschten Bruchkanten (A,B,C,D,E) mehr Material pro Längeneinheit abgetragen ist als in den übrigen Bereichen entlang der gewünschten Bruchkanten (A,B,C,D,E), **dadurch gekennzeichnet daß** die entlang einer gewünschten Bruchkante (A,B,C,D,E) verlaufende Länge (b) eines Eckbereichs (14) 0,5% bis 30% des entlang der gewünschten Bruchkante (A,B,C,D,E) verlaufenden Abstands (a) zwischen zwei benachbarten Eckpunkten (30) der gewünschten Bruchkante (A,B,C,D,E), an denen mindestens zwei gewünschte Bruchkanten (A,B,C,D,E) zusammentreffen, beträgt.

## Claims

1. Method for preparing the breaking up of a substrate (1) for at least one power semiconductor component having the following method steps:
a) preparing the substrate (1), wherein the substrate (1) has an electrically non-conductive insulating material body (2),
b) removal of material from the insulating material body (2) along desired fracture edges (A, B, C, D, E) of the substrate (1), wherein the removal of material is carried out in such a way that in corner regions (14) at which at least two desired fracture edges (A, B, C, D, E) meet a greater degree of removal of material is carried out along the at least two desired fracture edges compared to the removal of material which is carried out in the other regions (17) of the desired fracture edges (A, B, C, D, E), **characterized in that** the length (b) of a corner region (14), running along a desired fracture edge (A, B, C, D, E), is 0.5% to 30% of the distance (a), running along the desired fracture edge (A, B, C, D, E), between two adjacent corner points (30) of the desired fracture edge (A, B, C, D, E) at which at least two desired fracture edges (A, B, C, D, E) meet.

2. Method according to Claim 1, **characterized in that** the removal of material is carried out by means of a laser beam (20).

3. Method according to Claim 2, **characterized in that** the removal of material is carried out by means of a pulsed laser beam (20), and in order to bring about the removal of material, the pulsed laser beam (20) forms depressions (18, 18', 18") in the insulating material body (2) along the desired fracture edges (A, B, C, D, E).

4. Method according to Claim 3, **characterized in that** more depressions (18, 18') are made per unit length by the laser beam (20) in the insulating material body (2) along the desired fracture edges (A, B, C, D, E), in corner regions (14) at which at least two desired fracture edges meet, than in the other regions (17) of the desired fracture edges (A, B, C, D, E).

5. Method according to Claim 4, **characterized in that** the depressions (18, 18', 18") are made in the insulating material body (2) by the pulsed laser beam (20) **in that** in a first partial method step, first depressions (18') are made by the laser beam (20) in the insulating material body (2) along the desired fracture edges (A, B, C, D, E) of the substrate (1), and, in a second partial method step, second depressions (18') are made by the laser beam (20) in the insulating material body (2) along the desired fracture edges (A, B, C, D, E), in the corner regions (14) at which at least two desired fracture edges (A, B, C, D, E) meet.

6. Method according to Claim 5, **characterized in that** the first and second depressions (18, 18') are arranged in such a way that the centres (M) of the first and second depressions (18, 18') correspond locally, or the centres (M) of the first and second depressions (18, 18') are arranged offset with respect to one another.

7. Method according to one of Claims 2 to 6, **characterized in that** the power of the laser beam (20) is higher in the corner regions (14) at which at least two desired fracture edges (A, B, C, D, E) meet than the power of the laser beam (20) in the other regions (17) of the desired fracture edges (A, B, C, D, E).

8. Method according to Claim 5 or 6, **characterized in that** in the first and second partial method steps the laser beam (20) has the same power.

9. Method for breaking up a substrate for at least one power semiconductor component, wherein the method includes a method for preparing the breaking up of a substrate for at least one power semiconductor component according to one of the preceding claims, having the following further method step:
c) breaking up of the substrate (1) along the desired fracture edges (A, B, C, D, E) of the substrate (1).

10. Substrate for at least one power semiconductor component, wherein the substrate (1) has an electrically non-conductive insulating material body (2), wherein material of the insulating material body (2) is removed along desired fracture edges (A, B, C, D, E) of the substrate (1), wherein more material per unit length is removed along the at least two desired fracture edges (A, B, C, D, E) in corner regions (14) at which at least two desired fracture edges (A, B, C, D, E) meet than in the other regions along the desired fracture edges (A, B, C, D, E), **characterized in that** the length (b) of a corner region (14), running along a desired fracture edge (A, B, C, D, E), is 0.5% to 30% of the distance (a), running along the desired fracture edge (A, B, C, D, E), between two adjacent corner points (30) of the desired fracture edge (A, B, C, D, E) at which at least two desired fracture edges (A, B, C, D, E) meet.

## Revendications

1. Procédé destiné à préparer la rupture d'un substrat (1) pour au moins un composant semi-conducteur de puissance avec les étapes de procédé suivantes :
a) préparation du substrat (1), le substrat (1) comportant un corps en matière isolante (2) non électro-conducteur,
b) enlèvement de matière sur le corps en matière isolante (2) le long des bords de rupture souhaités (A, B, C, D, E) du substrat (1), l'enlèvement de matière étant exécuté de telle manière que dans les zones d'angle (14) sur lesquelles au moins deux bords de rupture souhaités (A, B, C, D, E) se rencontrent, le long d'au moins deux bords de rupture souhaités, est exécuté un enlèvement de matière plus important que l'enlèvement de matière exécuté dans les autres zones (17) des bords de rupture souhaités (A, B, C, D, E), **caractérisé en ce que** la longueur (b) d'une zone d'angle (14) passant le long d'un bord de rupture souhaité (A, B, C, D, E) est 0,5 % à 30 % de la distance (a) passant le long des bords de rupture souhaités (A, B, C, D, E) entre deux points d'angle voisins (30) des bords de rupture souhaités (A, B, C, D, E) sur lesquels au moins deux bords de rupture souhaités (A, B, C, D, E) se rencontrent.

2. Procédé selon l'une quelconque des revendications précédentes, **caractérisé en ce que** l'enlèvement de matière est exécuté au moyen d'un rayon laser (20).

3. Procédé selon la revendication 2, **caractérisé en ce que** l'enlèvement de matière est exécuté au moyen d'un rayon laser pulsé (20) et le rayon laser pulsé (20), pour obtenir l'enlèvement de matière, pratique des creux (18, 18', 18") dans le corps en matière isolante (2) le long des bords de rupture souhaités (A, B, C, D, E).

4. Procédé selon la revendication 3, **caractérisé en ce que** dans les zones d'angle (14) sur lesquelles au moins deux bords de rupture souhaités se rencontrent, plus de creux (18, 18') par unité de longueur sont pratiqués par le rayon laser (20) le long des bords de rupture souhaités (A, B, C, D, E) dans le corps en matière isolante (2) que dans les autres zones (17) des bords de rupture souhaités (A, B, C, D, E).

5. Procédé selon la revendication 4, **caractérisé en ce que** les creux (18, 18', 18") sont pratiqués par le rayon laser pulsé (20) dans le corps en matière isolante (2), les premiers creux (18') étant pratiqués au cours d'une première étape de procédé partiel par le rayon laser (20) le long des bords de rupture souhaités (A, B, C, D, E) du substrat (1) dans le corps en matière isolante (2) et les deuxièmes creux (18') étant pratiqués dans le corps en matière isolante (2) le long des bords de rupture souhaités (A, B, C, D, E) au cours d'une deuxième étape de procédé partiel par le rayon laser (20) dans les zones d'angle (14) sur lesquelles au moins deux bords de rupture souhaités (A, B, C, D, E) se rencontrent.

6. Procédé selon la revendication 5, **caractérisé en ce que** les premiers et deuxièmes creux (18, 18') sont disposés de telle manière que les centres (M) des premiers et deuxièmes creux (18, 18') coïncident localement ou les centres (M) des premiers et deuxièmes creux (18, 18') sont disposés décalés l'un par rapport à l'autre.

7. Procédé selon l'une quelconque des revendications 2 à 6, **caractérisé en ce que** dans les zones d'angle (14) sur lesquelles au moins deux bords de rupture souhaités (A, B, C, D, E) se rencontrent, la puissance du rayon laser (20) est plus élevée que la puissance du rayon laser (20) dans les autres zones (17) des bords de rupture souhaités (A, B, C, D, E).

8. Procédé selon la revendication 5 ou 6, **caractérisé en ce que** lors de la première et de la deuxième étape de procédé partiel, le rayon laser (20) présente la même puissance.

9. Procédé destiné à la rupture d'un substrat pour au moins un composant semi-conducteur de puissance, le procédé contenant un procédé destiné à la préparation de la rupture d'un substrat pour au moins un composant semi-conducteur de puissance selon l'une quelconque des revendications précédentes, avec une autre étape de procédé suivants :
c) rupture du substrat (1) le long des bords de rupture souhaités (A, B, C, D, E) du substrat (1).

10. Substrat pour au moins un composant semi-conducteur de puissance, le substrat (1) comportant un corps en matière isolante (2) non électroconducteur, de la matière du corps en matière isolante (2) étant enlevée le long des bords de rupture souhaités (A, B, C, D, E) du substrat (1), dans les zones d'angle (14) sur lesquelles au moins deux bords de rupture souhaités (A, B, C, D, E) se rencontrent, plus de matière étant enlevée par unité de longueur le long d'au moins deux bords de rupture souhaités (A, B, C, D, E) que dans les autres zones le long des bords de rupture souhaités (A, B, C, D, E), **caractérisé en ce que** la longueur (b) d'une zone d'angle (14) passant le long d'un bord de rupture souhaité (A, B, C, D, E) est 0,5 % à 30 % de la distance (a) passant le long des bords de rupture souhaités (A, B, C, D, E) entre deux points d'angle voisins (30) des bords de rupture souhaités (A, B, C, D, E) sur lesquels au moins deux bords de rupture souhaités (A, B, C, D, E) se rencontrent.
